(19) **Europäisches Patentamt / European Patent Office / Office européen des brevets**

(11) **EP 1 352 431 B2**

(12) # NEUE EUROPÄISCHE PATENTSCHRIFT
Nach dem Einspruchsverfahren

(45) Veröffentlichungstag und Bekanntmachung des Hinweises auf die Entscheidung über den Einspruch:
**07.08.2019   Patentblatt 2019/32**

(45) Hinweis auf die Patenterteilung:
**21.04.2010   Patentblatt 2010/16**

(21) Anmeldenummer: **01272551.1**

(22) Anmeldetag: **19.11.2001**

(51) Int Cl.:
**H01L 33/00** $^{(2010.01)}$

(86) Internationale Anmeldenummer:
**PCT/AT2001/000364**

(87) Internationale Veröffentlichungsnummer:
**WO 2002/054502 (11.07.2002 Gazette 2002/28)**

(54) **LICHTQUELLE MIT EINEM LICHTEMITTIERENDEN ELEMENT**

LIGHT SOURCE COMPRISING A LIGHT-EMITTING ELEMENT

SOURCE DE LUMIERE COMPRENANT UN ELEMENT D'EMISSION DE LUMIERE

(84) Benannte Vertragsstaaten:
**AT BE CH CY DE DK ES FI FR GB GR IE IT LI LU MC NL PT SE TR**

(30) Priorität: **28.12.2000   AT 21542000**

(43) Veröffentlichungstag der Anmeldung:
**15.10.2003   Patentblatt 2003/42**

(60) Teilanmeldung:
**08164012.0 / 2 006 924**
**10152099.7 / 2 211 392**
**12175718.1 / 2 544 247**
**11155555.3 / 2 357 678**

(73) Patentinhaber:
• **Tridonic Jennersdorf GmbH**
**8380 Jennersdorf (AT)**
• **Litec GBR**
**17489 Greifswald (DE)**
• **Leuchtstoffwerk Breitungen GmbH**
**98597 Breitungen (DE)**
• **TOYODA GOSEI CO., LTD.**
**Aichi-ken, 452-8564 (JP)**

(72) Erfinder:
• **TASCH, Stefan**
**A-8380 Jennersdorf (AT)**
• **PACHLER, Peter**
**A-8010 Graz (AT)**
• **ROTH, Gundula**
**17498 Levenhagen (DE)**
• **TEWS, Walter**
**17489 Greifswald (DE)**
• **KEMPFERT, Wolfgang**
**36448 Bad Liebenstein (DE)**
• **STARICK, Detlef**
**36448 Bad Liebenstein (DE)**

(74) Vertreter: **Rupp, Christian**
**Mitscherlich PartmbB**
**Patent- und Rechtsanwälte**
**Postfach 33 06 09**
**80066 München (DE)**

(56) Entgegenhaltungen:
EP-A2- 0 550 937         WO-A-00/33389
WO-A-00/33390         WO-A-01/89001
WO-A-98/05078         WO-A-98/12757
WO-A1-00/33389        WO-A1-00/33390
WO-A1-97/50132        WO-A1-98/39805
WO-A1-02/054502       WO-A2-99/02026
DE-A1- 19 730 006     DE-A-1- 19 806 213
US-A- 3 505 240       US-A- 6 084 250
US-A1- 2004 090 174

• POORT S H M ET AL: "Optical properties of Eu-activated orthosilicates and orthophosphates" JOURNAL OF ALLOYS AND COMPOUNDS, ELSEVIER SEQUOIA, LAUSANNE, CH, Bd. 260, Nr. 1, 12. September 1997 (1997-09-12), Seiten 93-97, XP004116136 ISSN: 0925-8388 in der Anmeldung erwähnt
• J. ELECTROCHEM. SOC., Bd. 115, Nr. 11, 1968, Seiten 1181-1184,
• LEDSMAGAZINE, 2005, Seiten 15-16,
• CEES RONDA: "Lumunescence" 2008, WILEY-VCH , WEINHEIM * Seite 179 - Seite 190 *

EP 1 352 431 B2

- THOMAS L BARRY: "Fluorescence of Eu2+-Activated Phase in Binary Alkaline Earth Orthosilicate systems", Journal of The Electrochemical Society, vol. 115, no. 11, 1 November 1968 (1968-11-01), pages 1181-1184, XP002502297,
- Annapoorna Akella ET AL: "Sr2LiSiO4F: Synthesis, Structure, and Eu2+ Luminescence", Chemistry of materials, vol. 7, no. 7, 1 July 1995 (1995-07-01), pages 1299-1302, XP055056274,
- "What wavelength goes with a color? Atmospheric science data center", , Retrieved from the Internet: URL:http://eosweb.larc.nasa.gov/EDDOCS/Wavelengths_for_Colors.html
- Poort S ET AL: "Optical properties of Eu-activated orthosilicates and orthophosphates", JOURNAL OF ALLOYS AND COMPOUNDS, vol. 260, no. 1, 12 September 1997 (1997-09-12), pages 93-97, XP004116136,

**Beschreibung**

TECHNISCHES GEBIET

Die vorliegende Erfindung betrifft eine Lichtquelle zur Erzeugung von weißem Licht, umfassend eine Licht-Emittierende-Diode (LED) zur Emission einer blauen Strahlung, und mindestens mit einen Luminophor, der einen Teil blauen Strahlung und selbst Strahlung in einem anderen Spektralbereich emittiert.

STAND DER TECHNIK

Anorganische LEDs zeichnen sich unter anderem durch hohe Lebensdauer, geringen Platzbedarf, Erschütterungsunempfindlichkeit und spektral engbandige Emission aus.

Zahlreiche Emissionsfarben - speziell spektral breitbandige - können mittels der intrinsischen Emission eines aktiven Halbleitermatorials in LEDs nicht oder nur ineffizient realisiert werden. Vor allem trifft dies auf die Erzeugung von weißem Licht zu.

In der WO 00/33390 ist ein Licht emittierendes Gerät gezeigt, welches eine ausschließlich blau emittierende LED oder Laserdiode umfasst, die mit einer Leuchtstoffmischung zusammenwirkt. Eine im Speklralbereich zwischen 420 und 470 nm emittierende LED wird dabei mit einer Leuchtstoffmischung aus mindestens zwei Leuchtstoffen kombiniert, um weißes Licht zu erzeugen. Die beiden zwingend notwendigen Leuchtstoffe müssen dazu mit unterschiedlichen Spektren emittieren. Die verwendete Leuchtstoffmischung umfasst immer eine Rotkomponente und eine Grünkomponente. Durch die Farbmischung mit der von der LED abgegebenen blauen Strahlung entsteht dann weißes Licht.

Gemäß dem Stand der Technik werden Emissionsfarben, welche mit dem Halbleiter intrinsisch nicht realisiert werden können, mittels Farbkonversion erzeugt.

Im Wesentlichen basiert die Technik der Farbkonversion auf dem Prinzip, dass zumindest ein Luminophor über dem LED-Die angeordnet wird. Dieser absorbiert einen Teil der vom Die emittierten Strahlung und wird dabei zur Photolumineszenz angeregt. Die Emissions- bzw. Lichtfarbe der Quelle ergibt sich dann aus der Mischung der transmittierten Strahlung des Die und der emittierten Strahlung des Leuchtstoffes.

Als Luminophore können grundsätzlich sowohl organische als auch anorganische Systeme eingesetzt werden. Der wesentliche Vorteil anorganischer Pigmente liegt in der höheren chemischen, Temperatur- und Strahlungsstabilität im Vergleich zu organischen Systemen. Im Zusammenhang mit der hohen Lebensdauer der anorganischen LEDs sichern langlebige anorganische Luminophore eine hohe Farbortstabilität der aus beiden Komponenten bestehenden Lichtquelle.

Soll die von blau emittierenden LEDs ausgesendete Strahlung in weißes Licht konvertiert werden, werden Leuchtstoffe benötigt, die das blaue Licht (450-490 nm) wirkungsvoll absorbieren und mit hoher Effizienz in größtenteils gelbe Lumineszenzstrahlung umwandeln. Allerdings gibt es nur eine geringe Anzahl anorganischer Luminophore, die diese Anforderungen erfüllen. Derzeit werden zumeist Materialien aus der YAG-Leuchtstoffklasse als Farbkonversionspigmente für blaue LEDs eingesetzt (WO 98/05078; WO 98/05078; WO 98/12757). Diese weisen allerdings den Nachteil auf, dass sie nur bei einem Emissionsmaximum kleiner als 560 nm eine genügend hohe Effizienz besitzen. Aus diesem Grund können mit den YAG-Pigmenten in Kombination mit blauen Dioden (450-490nm) nur kalt-weiße Lichtfarben mit Farbtemperaturen zwischen 6000 und 8000 K und mit vergleichsweise niedriger Farbwiedergabe (typische Werte für den Farbwiedergabeindex Ra liegen zwischen 70 und 75) realisiert werden. Daraus ergeben sich stark eingeschränkte Anwendungsmöglichkeiten. Zum einen werden bei der Anwendung von Weißlichtqucllen in der Allgemeinbeleuchtung in der Regel höhere Anforderungen an die Farbwiedergabequalität der Leuchtmittel gestellt, und zum anderen werden von den Konsumenten vor allem in Europa und in Nordamerika wärmere Lichtfarben mit Farbtemperaturen zwischen 2700 und 5000 K bevorzugt.

Aus der WO 00/33389 ist weiterhin bekannt, u.a. $Ba_2SiO_4:Eu^{2+}$ als Luminophor zur Konvertierung des Lichtes blauer LEDs zu verwenden. Das Maximum der Emission des Leuchtstoffes $Ba_2SiO_4:Eu^{2+}$ liegt aber bei 505 nm, so dass mit einer solchen Kombination mit Sicherheit kein weißes Licht erzeugt werden kann.

**STAND DER TECHNIK**

In der Arbeit von S.H.M. Poort et al: "Optical properties of Eu2+-activatcd orthosilicates and orthophospates", Journal of Alloys and Compounds 260 (1997), S 93-97 werden die Eigenschaften von Eu-aktiviertem $Ba_2SiO_4$ sowie von Phosphaten wie $KBaPO_4$ und $KSrPO_4$ untersucht. Auch hier wird festgestellt, dass die Emission von $Ba_2SiO_4$ bei etwa 505 nm liegt.

WO 00/19546 offenbart ein Beleuchtungssystem mit mindestens zwei Licht-emittierenden Dioden, wobei die mindestens zwei Licht-emittierenden Dioden mindestens eine ein blaues Licht emittierende Diode und mindestens eine ein rotes Licht emittierende Diode.

EP 1 352 431 B2

WO 01/89001, relevant unter Art 54(3) EPÜ, offenbart ein Beleuchtungssystem für weißes Licht umfassend eine LED, ein erstes lumineszentes Material mit einer maximalen Emission von 575-620 nm, ein zweites lumineszentes Material mit einer Emission von 495-550 nm, sowie ein drittes lumineszentes Material mit einer maximalen Emission von 420-480 nm.

OFFENBARUNG DER ERFINDUNG

Die Aufgabe der vorliegenden Erfindung besteht somit darin, eine verbesserte Lichtquelle bereitzustellen, die als Strahlungsquelle eine Licht-Emittierenden-Diode (LED) verwendet, wobei diese Strahlungsquelle im blauen Farbbereich emittieren kann, und die durch Einsatz eines verbesserten LeuchtsLoffs in der Lage ist, weißes Licht mit höherer Effizienz zu erzeugen, wodurch ein Einsatz dieser Weißlichtquelle für BeleuchLungszwecke erst möglich wird.

Gleichzeitig wird die Vermeidung der aus dem Stand der Technik bekannten Nachteile angestrebt. Dabei soll es weiterhin möglich sein, unter Verwendung eines oder mehrerer Leuchtstoffe die Farbtemperaturen in einem große Bereich einzustellen, um unterschiedliche Anforderungen der Nutzer zu erfüllen und insbesondere diejenigen Farborte einzustellen, die innerhalb der von der CIE für die Allgemeinbeleuchtung festgelegten Toleranzellipsen liegen.

Diese Aufgabe wird durch eine Lichtquelle gemäß Anspruch 1 gelöst.

Bei einer vorteilhaften Ausführungsform ist zumindest einer der Werte a, b, c und d größer als 0,01. Weiterhin kann in dem o.g. Luminophor ein Teil des Siliciums durch Gallium ersetzt sein.

Überraschenderweise wurde gefunden, dass weißes Licht mit guter Farbwiedergabe und hoher Lichtausbeute durch Kombination einer blauen LED mit einem Luminophor, ausgewählt: aus der Gruppe der erfindungsgemäßen europiumaktivierten Erdalkaliorthosilikäte oben genannter Zusammensetzung, realisiert werden kann. Im Gegensatz zu Luminophoren, die auf reinen Bariumorthosilikaten basieren und bläulich-grünes Licht ausstrahlen, kann nämlich durch Barium-Strontium-Orthosixikat-Mischkristalle gelb-grünes, gelbes bis qelb-orangetarbenes und durch Einbau von Calcium in das Orthosilikatgitter sogar vollständig orangefarbenes Lumineszenzlicht erzeugt werden, so dass dann durch Mischung des transmittierten Lichtes der blauen LED und des emittierten Lumineszenzlichtes des ausgewählten Luminophors weißes Licht hoher Farbwiedergabe und hoher Effizienz generiert werden kann. Die Verschiebung der Emissionsfarbe durch Substitution von Ba durch Sr in Orthosilikaten war bisher nur für die Anregung mit harter UV-Strahlung (254nm-Anregung) aus der oben genannten Arbeit von Poort et al. bekannt; dass dieser Effekt überraschender Weise verstärkt bei der Bestrahlung mit blauem Licht im Bereich von 440-475 nm auftritt, wurde dagegen noch nicht beschrieben. Ba-Sr-Ca-Orthosilikatmischkristalle und ihr starkes Emissionsvermögen bei Anregung mit langwelliger UV-Strahlung oder blauem Licht waren bisher gänzlich unbekannt.

Der ausgewählte Luminophor kann auch in Mischungen mit anderen Luminophoren dieser Gruppe und/oder mit zusätzlichen Leuchtstoffen, die nicht zu dieser Gruppe gehören, eingesetzt werden. Zu den letztgenannten Leuchtstoffen gehören z.B. blau emittierende Erdalkalialuminate, aktiviert mit zweiwertigem Europium und/oder Mangan, sowie die rot emittierenden Luminophore aus der Gruppe $Y(V,P,Si)O_4$ : Eu, Bi, $Y_2O_2S$:Eu,Bi oder aber europium- und manganaktivierte Erdalkali-Magnesium-disilikate :$Eu^{2+}$,$Mn^{2+}$ der Formel

$Me_{(3-x-y)}MgSi_2O_8$: xEu, yMn,

mit

$$0,005 < x < 0,5$$

$$0,005 < y < 0,5$$

und Me = Ba und/oder Sr und/oder Ca.

Wie in den unten angeführten Ausführungsbeispielen gezeigt wird, darf der Sr-Anteil in den erfindungsgemäßen Misch-kristall-Luminophoren nicht zu gering sein, um weißes Licht generieren zu können.

Überraschender Weise wurde weiters gefunden, dass der zusätzliche Einbau von $P_2O_5$, $Al_2O_3$ und/oder $B_2O_3$ in das Orthosilikatgitter sowie die Substitution eines Teils des Siliciums durch Germanium ebenfalls einen beträchtlichen Einfluss auf das Emissionsspektrum des jeweiligen Luminophors haben, so dass dieses für den jeweiligen Anwendungsfall in vorteilhafter Weise weiter variiert werden kann. Dabei bewirken kleinere Ionen als Si(IV) im Allgemeinen eine Verschiebung des Emissionsmaximum in den längerwelligen Bereich, während größere Ionen den Emissionsschwerpunkt zu kürzeren Wellenlängen verschieben. Weiterhin konnte gezeigt werden, dass es für die Kristallinität, das Emissionsvermögen und insbesondere für die Stabilität der erfindungsgemäßen Luminophore vorteilhaft sein kann, wenn zusätzlich geringe Mengen einwertiger Ionen wie z.B. Halogenide und/oder Alkalimetallionen in das Luminophorgitter eingebaut werden.

Gemäß einer weiteren vorteilhaften Ausgestaltung der Erfindung weist die Lichtquelle zumindest zwei verschiedene Luminophore auf, wobei zumindest einer ein Erdalkaliorthosilikatleuchtstoff ist. Auf diese Weise lässt sich der für die jeweilige Anwendung geforderte Weißton besonders genau einstellen und es lassen sich insbesondere Ra-Werte größer 80 erreichen.

Für die mechanische Ausführung der erfindungsgemäßen Lichtquelle gibt es mehrere Möglichkeiten. Gemäß einer Ausführungsform ist vorgesehen, dass ein oder mehrere LED-Chips auf einer Leiterplatte innerhalb eines Reflektors angeordnet sind und der Luminophor in einer Lichtscheibe, die über dem Reflektor angeordnet ist, dispergiert ist.

Es ist aber auch möglich, dass ein oder mehrere LED-Chips auf einer Leiterplatte innerhalb eines Reflektors angeordnet sind und der Luminophor auf dem Reflektor aufgebracht ist.

Vorzugsweise sind die LED-Chips mit einer transparenten Vergussmasse, die kuppelartige Form besitzt, vergossen. Diese Vergussmasse bildet einerseits einen mechanischen Schutz, andererseits verbessert sie auch die optischen Eigenschaften (besserer Austritt des Lichts aus den LED-Dice).

Der Luminophor kann auch in einer Vergussmasse dispergiert sein, die eine Anordnung von LED-Chips auf einer Leiterplatte und eine Polymerlinse möglichst ohne Gaseinschlüsse verbindet, wobei die Polymerlinse und die Vergussmasse Brechungsindizes aufweisen, die sich maximal um 0,1 unterscheiden. Diese Vergussmasse kann direkt die LED-Dice einschließen, es ist aber auch möglich, dass diese mit einer transparenten Vergussmasse vergossen sind (dann gibt es also eine transparente Vergussmasse und eine Vergussmasse mit dem Luminophor). Durch die ähnlichen Brechungsindizes gibt es an den Grenzflächen kaum Verluste durch Reflexion.

Vorzugsweise weist die Polymerlinse eine kugel- bzw. ellipsoidförmige Ausnehmung auf, welche durch die Vergussmasse ausgefüllt ist, sodass das LED-Array in geringem Abstand zur Polymerlinse befestigt ist. Auf diese Weise kann die Höhe des mechanischen Aufbaus verringert werden.

Um eine gleichmäßige Verteilung des Luminophors zu erreichen, ist es zweckmäßig, wenn der Luminophor in einer vorzugsweise anorganischen Matrix aufgeschlämmt ist.

Bei Verwendung von zumindest zwei Luminophoren ist es günstig, wenn die zumindest zwei Luminophore einzeln in Matrizen dispergiert sind, die in Lichtausbreitung hintereinander angeordnet sind. Dadurch kann die Konzentration der Luminophore im Vergleich zu einer einheitlichen Dispersion der verschiedenen Luminophore reduziert werden.

Nachfolgend sind die wesentlichen Schritte zur Herstellung der Luminophore in einer bevorzugten Variante der Erfindung dargestellt:

Für die Herstellung der Erdalkaliorthosilikat-Luminophore werden entsprechend der gewählten Zusammensetzung die stöchiometrischen Mengen der Ausgangsstoffe Erdalkalicarbonat, Siliciumdioxid sowie Europiumoxid innig gemischt und in einer für die Leuchtstoffherstellung üblichen Festkörperreaktion in reduzierender Atmosphäre bei Temperaturen zwischen 1100°C und 1400°C in den gewünschten Luminophor umgewandelt. Dabei ist es für die Kristallinität von Vorteil, der Reaktionsmischung kleine Anteile, vorzugsweise kleiner als 0,2 Mol, Ammoniumchlorid oder andere Halogenide zuzugeben. Im Sinne der aufgezeigten Erfindung kann auch ein Teil des Siliciums durch Germanium, Bor, Aluminium, Phosphor ersetzt werden, was durch Zugabe entsprechender Mengen von Verbindungen der genannten Elemente, die sich thermisch in Oxide zersetzen lassen, realisiert wird. In ähnlicher Weise kann erreicht werden, dass geringe Mengen von Alkalimetallionen in das jeweilige Gitter eingebaut werden.

Die erhaltenen erfindungsgemäßen Orthosilikatluminophore emittieren bei Wellenlängen zwischen etwa 510 nm und 600 nm und besitzen eine Halbwertsbreite bis zu 110 nm.

Durch entsprechende Gestaltung der Reaktionsparameter und durch bestimmte Zusätze, z.B. von einwertigen Halogenid-und/oder Alkalimetallionen, kann die Korngrößenverteilung der erfindungsgemäßen Luminophore an die Anforderungen der jeweiligen Anwendung optimal angepasst werden, ohne dass schädigende mechanische Zerkleinerungsprozesse durchgeführt werden müssen. Auf diese Weise lassen sich alle schmal- und breitbandigen Korngrößenverteilungen mit mittleren Korngrößen $d_{50}$ von etwa 2 $\mu$m bis 20 $\mu$m einstellen.

KURZE BESCHREIBUNG DER ZEICHNUNGEN

Weitere Vorteile der Erfindung werden im Folgenden anhand von Ausführungsbeispielen und Figuren erläutert.

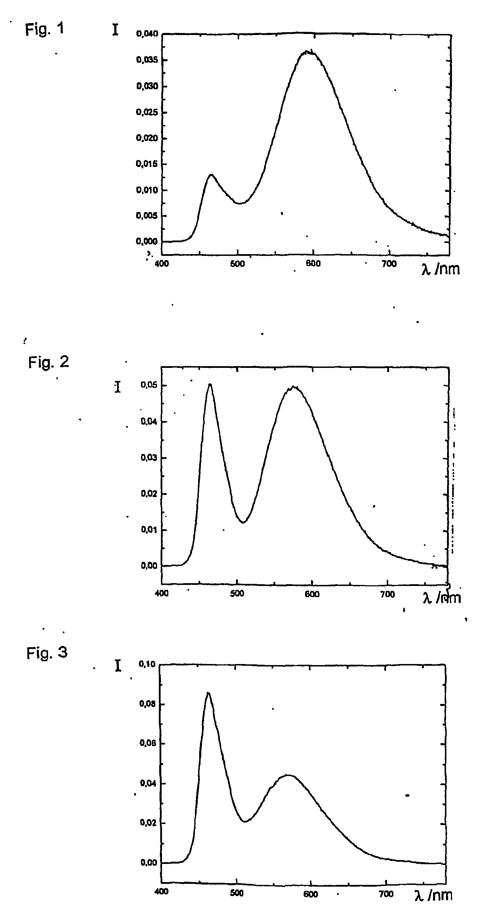

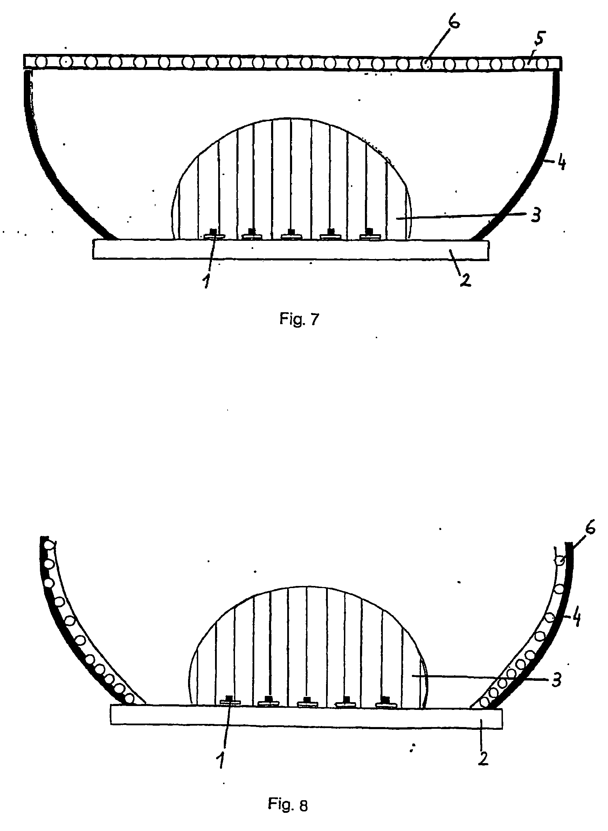

Fig. 1-6 zeigen Spektren (relative Intensität I abhängig von der Wellenlänge) verschiedener erfindungsgemäßer LED-Lichtquellen; und die Fig. 7-10 zeigen verschiedene Ausführungsformen erfindungsgemäßer LED-Lichtquellen.

BESTE AUSFÜHRUNGSFORMEN DER ERFINDUNG

Fig. 1 zeigt das Emissionsspektrum einer weißen LED mit einer Farbtemperatur von 2700 K, die durch Kombination einer in einem ersten Spektralbereich mit einer Schwerpunktswellenlänge von 464 nm emittierenden blauen LED und einem erfindungsgemäßen Luminophor der Zusammensetzung ($Sr_{1,4}Ca_{0,6}SiO_4:Eu^{2+}$), der in einem zweiten Spektralbereich mit einem Maximum von 596 nm emittiert, entstanden ist.

Weitere Beispiele für die Kombination einer bei 464 nm emittierenden LED mit jeweils einem der erfindungsgemäßen Othosilikatluminophore sind in den Fig. 2 und 3 dargestellt. Wird ein gelb emittierender Luminophor der Zusammensetzung $Sr_{1,90}Ba_{0,08}Ca_{0,02}SiO_4:Eu^{2+}$ zur Farbkonvertierung verwendet, kann eine Weißlichtfarbe mit einer Farbtemperatur von 4100 K eingestellt werden, während bei der Verwendung des Luminophors $Sr_{1,84}Ba_{0,16}SiO_4:Eu^{2+}$ beispielsweise eine Weißlichtquelle mit einer Farbtemperatur von 6500 K gefertigt werden kann.

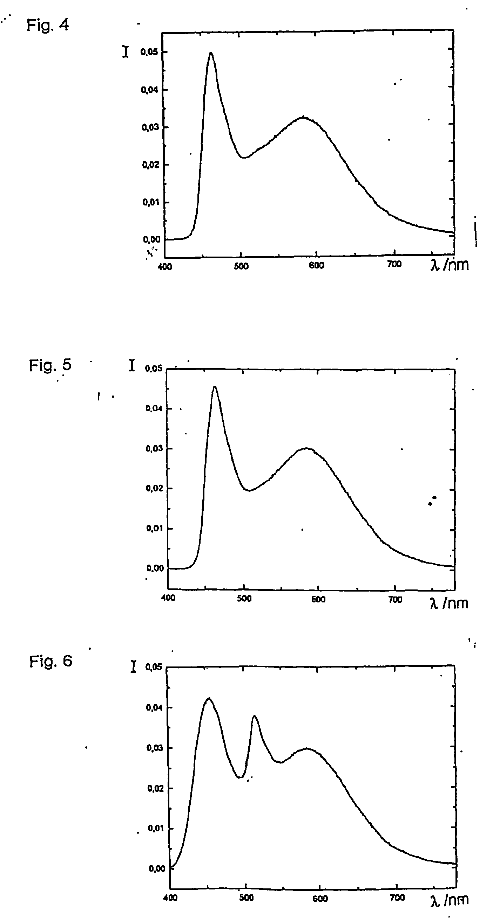

Ein typisches Spektrum für die Kombination einer 464 nm - LED mit zwei erfindungsgemäßen Orthosilikatluminophoren zeigt Fig. 4. Die verwendeten Leuchtstoffe weisen die Zusammensetzungen $Sr_{1,4}Ca_{0,6}SiO_4:Eu^{2+}$ und $Sr_{1,00}Ba_{1,00}SiO_4:Eu^2$ auf. Für das in der Abbildung 4 dargestellte konkrete Spektrum werden eine Farbtemperatur von 5088K und ein Farbwiedergabeindex Ra von 82 erhalten. Allerdings können in Abhängigkeit von den gewählten Mengenverhältnissen der Luminophore alle Farbtemperaturen im Bereich zwischen etwa 3500 K und 7500 K realisiert werden, wobei der große Vorteil derartiger Mischungen aus zwei erfindungsgemäßen Erdalkaliorthosilikat-Luminophoren vor allem darin besteht, dass zugleich Ra-Werte größer 80 erreicht werden können.

Das wird in der Fig. 5 beispielhaft dokumentiert. Das dargestellte Spektrum steht für die Kombination einer 464 nm - LED mit einer Mischung aus den zwei Luminophoren $Sr_{1,6}Ca_{0,4}Si_{0,98}Ga_{0,02}O_4:Eu^{2+}$ und $Sr_{1,10}Ba_{0,90}SiO_4:Eu^2$ und liefert bei einer Farbtemperatur von 5000K einen Ra-Werte von 82.

Wird als strahlungsemittierendes Element eine nicht-erfindungsgemäße UV-LED verwendet, die in einem ersten Spektralbereich mit einem Maximum von 370-390nm emittiert, dann lassen sich durch Kombination einer solchen LED mit einer Leuchtstoffmischung, die die erfindungsgemäßen Luminophore von Fig. 4 und zugleich einen bestimmten Anteil eines blau-grün emittierenden Barium-Magnesium-Aluminatleuchtstoff:Eu,Mn enthält, Ra-Werte größer 90 realisieren. Die Fig. 6 zeigt das Emissionsspektrum einer entsprechenden Weißlichtquelle, die bei einer Farbtemperatur von 6500K einen Ra von 91 aufweist.

Weitere Bespiele sind der folgenden Aufstellung zu entnehmen. Dabei wurden neben der Emissionswellenlänge der verwendeten anorganischen LED und der jeweiligen Zusammensetzung der erfindungsgemäßen Luminophore die resultierenden Farbtemperaturen und Ra-Werte sowie die Farborte der Lichtquellen angegeben:

T = 2778 K (464 nm + $Sr_{1,4}Ca_{0,6}SiO_4:Eu^{2+}$); x = 0,4619, y = 0,4247, Ra = 72

T = 2950 K (464 nm + $Sr_{1,4}Ca_{0,6}SiO_4:Eu^{2+}$) ; x = 0,4380, y = 0,4004, Ra = 73

T = 3497 K (464 nm + $Sr_{1,6}Ba_{0,4}SiO_4:Eu^{2+}$); x = 0,4086, y = 0,3996, Ra = 74

T = 4183 K (464 nm + $Sr_{1,9}Ba_{0,08} Ca_{0,02} SiO_4:Eu^{2+}$) ; x = 0,3762, y = 0,3873, Ra = 75

T = 6624 K (464 nm + $Sr_{1,9} Ba_{0,02} Ca_{0,08} SiO_4:Eu^{2+}$);X = 0,3101, y = 0,3306, Ra = 76

T = 6385 K (464 nm + $Sr_{1,6}Ca_{0,4}SiO_4:Eu^{2+}$ + $Sr_{0,4}Ba_{1,6}SiO_4:Eu^{2+}$); x = 0,3135, y = 0,3397, Ra = 82

T = 4216 K (464 nm + $Sr_{1,9}Ba_{0,08} Ca_{0,02} SiO_4:Eu^{2+}$));x = 0,3710, y = 0,3696, Ra = 82

3954 K (464 nm + $Sr_{1,6}Ba_{0,4}SiO_4:Eu^{2+}$+ $Sr_{0,4}Ba_{1,6}SiO_4:Eu^{2+}$ + $YVO_4:Eu^{3+}$) ; x = 0,3756, y = 0,3816, Ra = 84

T = 6489 K (UV-LED + $Sr_{1,6}Ca_{0,4}SiO_4:Eu^{2+}$ + $Sr_{0,4}Ba_{1,6}SiO_4:Eu^{2+}$ + Barium-Magnesium-Aluminat: $Eu^{2+}$); x = 0,3115, y = 0,3390, Ra = 86 (nicht erfindungsgemäß)

T = 5097 K (464 nm + $Sr_{1,6}Ba_{0,4}(Si_{0,98}B_{0,02})O_4:Eu^{2+}$ + $Sr_{0,6}Ba_{1,4}SiO_4:Eu^{2+}$) ; x = 0,3423, y = 0,3485, Ra = 82

T = 5084 K (UV-LED + $Sr_{1,6}Ca_{0,4}(Si_{0,4}(Si_{0,99}B_{0,01})O_4:Eu^{2+}$+ . $Sr_{0,6}Ba_{1,4}SiO_4:Eu^{2+}$ +Strontium-Magnesium-Aluminat: $Eu^{2+}$); x = 0,3430, y = 0,3531, Ra = 83 (nicht erfindungsgemäß)

T = 3369 K (464 nm + $Sr_{1,4}Ca_{0,6}Si_{0,95} Ge_{0,05}O_4:Eu^{2+}$); x = 0,4134, y = 0,3959, Ra = 74

T = 2787 K (466 nm + $Sr_{1,4}Ca_{0,6}Si_{0,98}P_{0,02}O_{4,01}:Eu^{2+}$); x = 0,4630, y =0,4280, Ra = 72

T = 2913 K (464 nm + $Sr_{1,4}Ca_{0,6}Si_{0,98}Al_{0,02}O_4:Eu^{2+}$) ; x = 0,4425, y = 0,4050, Ra = 73

T= 4201 K

In einer bevorzugten Variante der Erfindung wird die Farbkonversion folgendermaßen durchgeführt:

Ein oder mehrere LED-Chips 1 (siehe Fig. 7) werden auf einer Leiterplatte 2 assembliert. Direkt über den LEDs wird (einerseits zum Schutz der LED-Chips und andererseits um das im LED-Chip erzeugte Licht besser auskoppeln zu können) ein Einkapselmittel 3 in der Form einer Halbkugel oder eines Halbellipsoids angeordnet. Dieses Verkapselmittel 3 kann entweder jeden Die einzeln umfassen, oder es kann eine gemeinsame Form für alle LEDs darstellen. Die derart bestückte Leiterplatte 2 wird in einen Reflektor 4 eingesetzt bzw. dieser wird über die LED-Chips 1 gestülpt.

Auf den Reflektor 4 wird eine Lichtscheibe 5 gesetzt. Diese dient einerseits dem Schutz der Anordnung, anderseits werden in diese Lichtscheibe die Luminophore 6 eingemischt. Das blaue Licht das durch die Lichtscheibe 5 hindurchtritt, wird beim Durchgang anteilig durch den Luminophor 6 in einen zweiten Spektralbereich konvertiert, so dass sich insgesamt ein weißer Farbeindruck ergibt. Verluste durch waveguiding-Effekte, wie diese bei planparallelen Platten auftreten, werden durch die opaken, streuenden Eigenschaften der Scheibe reduziert. Weiterhin sorgt der Reflektor 4 dafür, dass nur bereits vorgerichtetes Licht auf die Lichtscheibe 5 auftrifft, so dass Totalreflexionseffekte von vornherein reduziert werden.

Es ist auch möglich, den Luminophor 6 auf den Reflektor 4 aufzutragen, wie dies in Fig. 8 dargestellt ist. Es ist dann keine Lichtscheibe erforderlich.

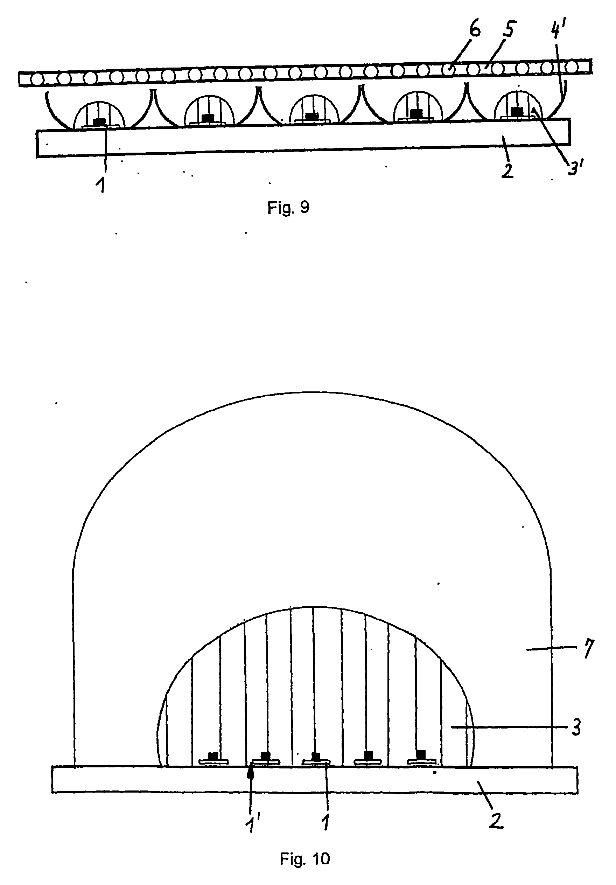

Alternativ dazu kann über jedem LED-Chip 1 (siehe Fig. 9) ein Reflektor 4' aufgesetzt sein und dieser kuppelförmig ausgegossen werden (Einkapselmittel 3') und eine Lichtscheibe 5 über jedem Reflektor 3' bzw. über der gesamten Anordnung angeordnet werden.

Für die Herstellung von Beleuchtungsquellen ist es zweckmäßig, anstelle von Einzel-LEDs LED-Arrays zu verwenden. In einer bevorzugten Variante der Erfindung wird die Farbkonversion auf einem LED-Array 1' (siehe Fig. 10), bei welchem die LED-Chips 1 direkt auf der Leiterplatte 2 assembliert werden, in folgender Form durchgeführt:

Ein LED-Array 1' (siehe Fig. 10) wird mittels einer Vergussmasse 3 (z.B. Epoxid) an eine transparente Polymerlinse 7, die aus einem anderen Material (z.B. PMMA) besteht, angeklebt. Das Material der Polymerlinse 7 und der Vergussmasse 3 werden derart ausgewählt, dass diese möglichst ähnliche Brechzahlen aufweisen - also phasenangepasst sind. Die Vergussmasse 3 befindet sich in einer maximal kugelförmigen oder ellipsoidförmigen Aushöhlung der Polymerlinse 7. Die Form der Aushöhlung ist insofern von Bedeutung, da in der Vergussmasse 3 das Farbkonversionsmaterial dispergiert ist, und daher durch die Formgebung sichergestellt werden kann, dass winkelunabhängige Emissionsfarben erzeugt werden. Alternativ dazu kann das Array zuerst mit einer transparenten Vergussmasse vergossen werden und anschließend mittels der Vergussmasse, die das Farbkonversionsmaterial beinhaltet, an die Polymerlinse geklebt werden.

Zur Herstellung weißer LEDs mit besonders guter Farbwiedergabe, bei denen zumindest zwei verschiedene Luminophore eingesetzt werden, ist es günstig, diese nicht gemeinsam in einer Matrix zu dispergieren, sondern diese getrennt zu dispergieren und aufzubringen. Dies gilt speziell für Kombinationen, bei denen die endgültige Lichtfarbe durch einen mehrstufigen Farbkonversionsprozess erzeugt wird. D.h., dass die langwelligste Emissionsfarbe durch einen Emissionsprozess generiert wird, der wie folgt abläuft: Absorption der LED-Emission durch den ersten Luminophor - Emission des ersten Luminophors - Absorption der Emission des ersten Luminophors durch den zweiten Luminophor und Emission des zweiten Luminophors. Speziell für einen derartigen Prozess ist es zu bevorzugen, die einzelnen Materialien in Lichtausbreitungsrichtung hintereinander anzuordnen, da damit die Konzentration der Materialien im Vergleich zu einer einheitlichen Dispersion der verschiedenen Materialien reduziert werden kann.

Die vorliegende Erfindung ist nicht auf die beschriebenen Beispiele eingeschränkt. Die Luminophore könnten auch in der Polymerlinse (oder einer anderen Optik) eingebracht sein. Es ist auch möglich, den Luminophor direkt über dem LED-Dice oder auf der Oberfläche der transparenten Vergussmasse anzuordnen. Auch kann der Luminophor zusammen mit Streupartikeln in eine Matrix eingebracht werden. Dadurch wird ein Absinken in der Matrix verhindert und ein gleichmäßiger Lichtaustritt gewährleistet.

## Patentansprüche

1. Lichtquelle zur Erzeugung von weißem Licht, umfassend eine LichtEmittierende-Diode (LED) zur Emission einer blauen Strahlung, und mindestens einen Luminophor, der einen Teil der blauen Strahlung absorbiert und selbst Strahlung in einem anderen Spektralbereich emittiert, **dadurch gekennzeichnet, dass**

   • der Luminophor ein mit zweiwertigem Europium aktiviertes Erdalkaliorthosilikat einer der nachfolgenden Zusammensetzungen oder einer Mischung aus diesen Zusammensetzungen ist:

   a) $(2-x-y)SrO \cdot x(Ba_u, Ca_v)O \cdot (1-a-b-c-d)SiO_2 \cdot aP_2O_5\ bAl_2O_3\ cB_2O_3\ dGeO_2: yEu^{2+}$ wobei

   $$0 \leq x < 1{,}6 \qquad 0{,}005 < y < 0{,}5 \qquad x + y \leq 1{,}6$$
   $$0 \leq a, b, c, d < 0{,}5 \qquad u + v = 1$$

gilt,

b) $(2-x-y)BaO \cdot x(Sr_u, Ca_v)O \cdot (1-a-b-c-d)SiO_2 \cdot aP_2O_5\ bAl_2O_3\ cB_2O_3\ dGeO_2{:}y\ Eu^{2+}$ wobei

$$0,01 < x < 1,6 \qquad 0,005 < y < 0,5$$
$$0 \le a, b, c, d < 0,5 \qquad u+v=1 \qquad x \cdot u \ge 0,4$$

gilt;

• der Luminophor Strahlung im gelb-grünen, gelben oder orangefarbigen Spektralbereich emittiert, deren Charakteristik von den Parametern x, y, u, v, a, b, c und d abhängig ist;

• durch Auswahl der Parameter in den genannten Bereichen die Farbtemperatur und der Farbwiedergabeindex des erzeugten weißen Lichts einstellbar sind, wobei die mittlere Korngröße $d_{50}$ der Volumenverteilung des Luminophors zwischen 2 $\mu$m und 20 $\mu$m liegt.

2. Lichtquelle nach Anspruch 1, **dadurch gekennzeichnet, dass** zumindest einer der Werte a, b, c und d größer als 0,01 ist.

3. Lichtquelle nach Anspruch 1 oder 2, **dadurch gekennzeichnet, dass** sie einen zusätzlichen Luminophor aus der Gruppe der Erdalkalialuminate, aktiviert mit zweiwertigem Europium und/oder Mangan, und/oder einen weiteren zusätzlichen rotemittierenden Luminophor aus der Gruppe $Y(V,P,Si)O_4{:}Eu,Bi$, $Y_2O_2S{:}Eu,Bi$ oder Erdalkali-Magnesiumdisilikat $:Eu^{2+},Mn^{2+}$ enthält, mit der Formel
$Me_{(3-x-y)}MgSi_2O_8{:}xEu,\ yMn$,
wobei

$$0,005 < x < 0,5 \qquad 0,005 < y < 0,5$$

und Me=Ba und/oder Sr und/oder Ca
gilt.

4. Lichtquelle nach einem der Ansprüche 1 bis 3, **dadurch gekennzeichnet, dass** einwertige Ionen, insbesondere Halogenide und/oder Alkalimetalle, in das Luminophorgitter eingebaut sind.

5. Lichtquelle nach einem der Ansprüche 1 bis 4, **dadurch gekennzeichnet, dass** ein oder mehrere LED-Chips (1) auf einer Leiterplatte (2) innerhalb eines Reflektors (4) angeordnet sind und der Luminophor (6) in einer Lichtscheibe (5), die über dem Reflektor 4 angeordnet ist, dispergiert ist.

6. Lichtquelle nach einem der Ansprüche 1 bis 4, **dadurch gekennzeichnet, dass** ein oder mehrere LED-Chips (1) auf einer Leiterplatte (2) innerhalb eines Reflektors (4) angeordnet sind und der Luminophor (6) auf dem Reflektor (4) aufgebracht ist.

7. Lichtquelle nach Anspruch 5 oder 6, **dadurch gekennzeichnet, dass** die LED-Chips (1) mit einer transparenten Vergussmasse (3, 3'), die eine kuppelartige Form besitzt, vergossen sind.

8. Lichtquelle nach einem der Ansprüche 1 bis 4, **dadurch gekennzeichnet, dass** der Luminophor in einer Vergussmasse (3) dispergiert ist, die eine Anordnung (1') von LED-Chips (1) auf einer Leiterplatte (2) und eine Polymerlinse (7) möglichst ohne Gaseinschlüsse verbindet, wobei die Polymerlinse (7) und die Vergussmasse (3) Brechungsindizes aufweisen, die sich maximal um 0,1 unterscheiden.

9. Lichtquelle nach Anspruch 8, **dadurch gekennzeichnet, dass** die Polymerlinse (7) eine kugel- bzw. ellipsoidförmige Ausnehmung aufweist, welche durch die Vergussmasse (3) ausgefüllt ist, so dass die LED-Anordnung (1') in geringem Abstand zur Polymerlinse (7) befestigt ist.

10. Lichtquelle nach einem der Ansprüche 1 bis 9, **dadurch gekennzeichnet, dass** der Luminophor in einer vorzugsweise anorganischen Matrix aufgeschlämmt ist.

11. Lichtquelle nach Anspruch 3 und 10, **dadurch gekennzeichnet, dass** die zumindest zwei Luminophore einzeln in Matrizen dispergiert sind, die in Lichtausbreitung hintereinander angeordnet sind.

**Claims**

1. Light source to generate white light, comprising a Light-Emitting Diode (LED) to emit blue emission, and at least one luminophore that absorbs a portion of the blue emission and itself emits emission in another spectral region, **characterized in that**,

   • the luminophore is an alkaline-earth ortho-silicate activated with bivalent Europium of one of the following compounds or a mixture of these compounds :

   a) $(2-x-y)SrO \cdot x(Ba_u, Ca_v)O \cdot (1-a-b-c-d)SiO_2 \cdot aP_2O_5 \, bAl_2O_3 \, cB_2O_3 \, dGeO_2: yEu^{2+}$ where

   $$0 \leq x < 1,6 \qquad 0,005 < y < 0,5 \qquad x + y \leq 1,6$$
   $$0 \leq a,b,c,d < 0,5 \qquad u + v = 1$$

   apply,
   b) $(2-x-y)BaO \cdot x(Sru, Cav)O \cdot (1-a-b-c-d)SiO_2 \cdot aP_2O_5 \, bAl_2O_3 \, cB_2O_3 \, dGeO_2:y \, Eu^{2+}$ where

   $$0,01 < x < 1,6 \qquad 0,005 < y < 0,5$$
   $$0 \leq a,b,c,d < 0,5 \qquad u+v=1 \qquad x \cdot u \geq 0,4$$

   apply;

   • the luminophore emits emission in the yellow-green, yellow, or orange spectral regions, whose characteristic depends on the parameters x, y, u, v, a, b, c, and d;
   • the color temperature and color rendering index of the created white light may be adjusted by selection of parameters in the above-mentioned regions, wherein the mean grain size d50 of volumetric distribution of the luminophore lies between 2 $\mu$m and 20 $\mu$m.

2. Light source as in Claim 1, **characterized in that** at least one of the values a, b, c, and d are greater than 0.01.

3. Light source as in Claims 1 or 2, **characterized in that** it contains an additional luminophore from the group of alkaline-earth aluminates activated using bivalent Europium and/or Manganese, and/or a second, additional red-emitting luminophore of the group $Y(V,P,Si)O_4:Eu,Bi$, $Y_2O_2S:Eu,Bi$ or alkaline-earth Magnesium di-silicates: $Eu^{2+},Mn^{2+}$ according to the formula:
   $Me_{(3-x-y)}MgSi_2O_8:xEu, yMn,$
   where

   $$0,005 < x < 0,5 \qquad 0,005 < y < 0,5$$

   and Me=Ba and/or Sr and/or Ca
   apply.

4. Light source as in one of Claims 1 to 3, **characterized in that** monovalent ions, particularly halogenides and/or alkali metals, are incorporated into the lattice of the luminophore lattice.

5. Light source as in one of Claims 1 to 4, **characterized in that** one or more LED chips (1) are arranged on a circuit board (2) within a reflector (4), and the luminophore (6) is dispersed within a light disk (5) positioned above the reflector (4).

6. Light source as in one of Claims 1 to 4, **characterized in that** one or more LED chips (1) are arranged on a circuit board (2) within a reflector (4), and the luminophore (6) is mounted onto the reflector (4).

7. Light source as in Claim 5 or 6, **characterized in that** the LED chips (1) are casted together with a transparent casting compound (3, 3') having a domed shape.

8. Light source as in one of Claims 1 to 4, **characterized in that** the luminophore is dispersed within a casting compound (3) that connects an arrangement (1') of LED chips (1) on a circuit board (2) and a polymer lens (7) preferably without any gas voids incorporated, wherein the polymer lens (7) and the casting compound (3) have refractive indices which differ from each other with not more than 0.1 at the most.

9. Light source as in Claim 8, **characterized in that** the polymer lens (7) has a spherical- or ellipsoid-shaped recess being filled with the casting compound (3), so that the LED arrangement (1') is positioned to the polymer lens (7) within a small distance.

10. Light source as in one of Claims 1 to 9, **characterized in that** the luminophore is incorporated into a slurry of a preferably inorganic matrix.

11. Light source as in Claims 3 and 10, wherein the at least two luminophores are dispersed individually within matrices and are positioned one after the other in the direction of light spread.

**Revendications**

1. Source lumineuse pour générer de la lumière blanche, comprenant une diode émettrice de lumière (LED) pour l'émission d'un rayonnement bleu, et au moins un luminophore, qui absorbe une partie du rayonnement bleu et émet lui-même du rayonnement dans une autre plage spectrale, **caractérisée en ce que**

   • le luminophore est un orthosilicate alcalino-terreux activé avec de l'europium bivalent de l'une des compositions suivantes ou d'un mélange de ces compositions :

   a) $(2-x-y)SrO \cdot x(Ba_u, Ca_v)O \cdot (1-a-b-c-d)SiO_2 \cdot aP_2O_5bAl_2O_3cB_2O_3dGeO_2{:}yEu^{2+}$ formule dans laquelle on a

   $$0 \leq x < 1,6 \qquad 0,005 < y < 0,5 \qquad x + y \leq 1,6$$
   $$0 \leq a, b, c, d < 0,5 \qquad u + v = 1$$

   b) $(2-x-y)BaO \cdot x(Sr_u, Ca_v)O \cdot (1-a-b-c-d)SiO_2 \cdot aP_2O_5bAl_2O_3cB_2O_3dGeO_2{:}y\,Eu^{2+}$ formule dans laquelle on a

   $$0,01 < x < 1,6 \qquad 0,005 < y < 0,5$$
   $$0 \leq a,b,c,d < 0,5 \qquad u + v = 1 \qquad x \cdot u \geq 0,4$$

   • le luminophore émet du rayonnement dans la plage spectrale jaune-verte, jaune ou couleur orange, dont la caractéristique est dépendante des paramètres x, y, u, v, a, b, c et d ;
   • la température de couleur et l'indice de restitution de couleur de la lumière blanche générée peuvent être réglés par le choix des paramètres dans lesdites plages, la grosseur de grain moyenne $d_{50}$ de la répartition de volume du luminophore se situant entre 2 $\mu$m et 20 $\mu$m.

2. Source lumineuse selon la revendication 1, **caractérisée en ce qu'**au moins l'une des valeurs a, b, c et d est supérieure à 0,01.

3. Source lumineuse selon la revendication 1 ou 2, **caractérisée en ce qu'**elle contient un luminophore supplémentaire provenant du groupe des aluminates alcalino-terreux, activé avec de l'europium bivalent et/ou du manganèse, et/ou un autre luminophore supplémentaire émettant en rouge provenant du groupe $Y(V,P,Si)O_4{:}Eu,Bi, Y_2O_2S{:}Eu,Bi$ ou du silicate de magnésium alcalino-terreux :$Eu^{2+},Mn^{2+}$, avec la formule
$Me_{(3-x-y)}MgSi_2O_8{:}xEu, yMn,$
dans laquelle on a $0,005 < x < 0,5$ $0,005 < y < 0,5$ et Me = Ba et/ou Sr et/ou Ca.

4. Source lumineuse selon l'une quelconque des revendications 1 à 3, **caractérisée en ce que** des ions univalents, en particulier des halogénures et/ou des métaux alcalins, sont intégrés dans le réseau de luminophore.

**5.** Source lumineuse selon l'une quelconque des revendications 1 à 4, **caractérisée en ce qu'**une ou plusieurs puces à LED (1) sont disposées sur une carte imprimée (2) à l'intérieur d'un réflecteur (4) et le luminophore (6) est dispersé dans un disque lumineux (5) qui est disposé au-dessus du réflecteur (4).

**6.** Source lumineuse selon l'une quelconque des revendications 1 à 4, **caractérisée en ce qu'**une ou plusieurs puces à LED (1) sont disposées sur une carte imprimée (2) à l'intérieur d'un réflecteur (4) et le luminophore (6) est appliqué sur le réflecteur (4).

**7.** Source lumineuse selon la revendication 5 ou 6, **caractérisée en ce que** les puces à LED (1) sont coulées avec une masse de scellement (3, 3') transparente, qui présente une forme de type coupole.

**8.** Source lumineuse selon l'une quelconque des revendications 1 à 4, **caractérisée en ce que** le luminophore est dispersé dans une masse de scellement (3), qui relie un agencement (1') de puces à LED (1) sur une carte imprimée (2) et une lentille en polymère (7) si possible sans inclusions de gaz, la lentille en polymère (7) et la masse de scellement (3) présentant des indices de réfraction qui se différencient au maximum de 0,1.

**9.** Source lumineuse selon la revendication 8, **caractérisée en ce que** la lentille en polymère (7) présente un évidement en forme de cône ou d'ellipsoïde, qui est rempli par la masse de scellement (3), de sorte que l'agencement des LEDs (1') est fixé à une faible distance de la lentille en polymère (7).

**10.** Source lumineuse selon l'une quelconque des revendications 1 à 9, **caractérisée en ce que** le luminophore est mis en suspension dans une matrice de préférence inorganique.

**11.** Source lumineuse selon les revendications 3 et 10, **caractérisée en ce qu'**au moins deux luminophores sont dispersés individuellement dans des matrices qui sont disposées dans une propagation de lumière les unes derrière les autres.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0033390 A
- WO 9805078 A
- WO 9812757 A

- WO 0033389 A
- WO 0019546 A
- WO 0189001 A

**In der Beschreibung aufgeführte Nicht-Patentliteratur**

- **S.H.M. POORT et al.** Optical properties of Eu2+-activatcd orthosilicates and orthophospates. *Journal of Alloys and Compounds,* 1997, vol. 260, 93-97